# EUROPÄISCHE PATENTSCHRIFT

(11) **EP 2 124 302 B1**
(45) Veröffentlichungstag und Bekanntmachung des Hinweises auf die Patenterteilung: **06.01.2010**
(21) Anmeldenummer: 08009356.0
(22) Anmeldetag: 21.05.2008
(51) Int. Cl.: H02B 1/20

(54) **Rahmengestell für eine Prüfzelle**
Frame for a test cell
Baie pour une cellule d'essai

(43) Veröffentlichungstag der Anmeldung: 25.11.2009
(73) Patentinhaber: Wurmhöringer, Klaus, 71131 Jettingen (DE)
(72) Erfinder: Wurmhöringer, Klaus, 71131 Jettingen (DE)
(74) Vertreter: Späth, Dieter

(56) Entgegenhaltungen:
- EP-A- 0 866 531
- EP-A- 0 932 231
- WO-A-03/012947
- FR-A- 2 761 569
- US-A- 5 761 797

## Beschreibung

Die Erfindung betrifft ein Rahmengestell für eine Prüfzelle, mit vertikalen Pfosten und horizontalen Querstreben, wobei die Querstreben an Endabschnitten mit den Pfosten verbunden sind. Im üblichen Sprachgebrauch werden Prüfzellen oft auch als Prüfstände bezeichnet und weisen mindestens einen Prüfaufbau, technische Versorgungseinrichtungen sowie häufig integrierte Messgeräte auf. Die technischen Versorgungseinrichtungen, der Prüfaufbau und die Messgeräte sind dabei mit elektrischen, pneumatischen bzw. hydraulischen Leitungen miteinander verbunden, wobei die elektrischen Leitungen Spannungsversorgungs-, Steuersowie Sensorleitungen umfassen können.

Rahmengestelle sind in der Praxis zum Tragen von Prüfeinrichtungen weit verbreitet. Derartige Rahmengestelle weisen in der Regel mindestens vier vertikale Pfosten sowie eine Anzahl von horizontalen Querstreben auf, die sich jeweils zueinander senkrecht erstrecken. Die horizontalen Querstreben sind mit den vertikalen Pfosten durch eine Schraub-, Press- oder Schweißverbindung lös-oder unlösbar verbunden, wobei die Querstreben an Endabschnitten mit den vertikalen Pfosten verbunden sind. An einem solchen Rahmengestell sind üblicherweise Trägerplatten für Profaufbauten und/oder Stellplatten für Messgeräte vorgesehen, die von den Pfosten und/oder den Querstreben gehalten werden.

Aus dem Gebrauchsmuster DE 202 07 426 U1 ist ein Rahmengestell für einen Schrank, insbesondere für einen Geräte- und Schaltschrank bekannt, das einen unteren und einen oberen Rahmen sowie front- und rückseitige Vertikalprofile aufweist. Die Vertikalprofile sind als Hohlprofile ausgebildet und verbinden den unteren mit dem oberen Rahmen. Dabei sind die frontseitigen Vertikalprofile und die rückseitigen Vertikalprofile im Querschnitt als offene Mehrkammerprofile vorgesehen, wobei wenigstens die rückseitigen Vertikalprofile zur Kabelführung ausgebildet sind.

Des weiteren ist aus der US 5,761,797 A ein Verfahren zum Aufbau eines Schaltschrankes und zum Einbau und Verdrahten von in dem Schaltschrank unterzubringenden Einbauten, wie Montageplatten, Montageschienen, Baugruppenträgern, Installationsgeräten und dergleichen bekannt. Der Schaltschrank weist ein Rahmengestell aus Rahmenschenkeln, mindestens eine Schranktür und Wandelemente auf. An der Unterseite des Rahmengestells sind Kabeleinführungen in den Schaltschrank vorgesehen. Die Einbeziehung des Einbaus von Einbauten in den Aufbau des Rahmengestells und die abschließende Verkleidung des Rahmengestells mit Schranktür und Wandelementen erleichtert den Einbau der Einbauten wesentlich. Der Einbau und die Verdrahtung der Einbauten ist einfach, da die Schranktür und die Wandelemente abnehmbar sind und das offene Rahmengestell allseitigen Zugang zur dem Innenraum des Schaltschrankes gewährt.

Prüfzellen finden vorwiegend in Fertigungs- und Laborbereichen Anwendung. Diese Zellen erfordern eine möglichst geordnete und übersichtliche Leitungsführung, die vor allem den Arbeitsschutz- und sicherheitstechnischen Bestimmungen entsprechen muss. Häufig sind die Einrichtungen der Prüfzellen jedoch über freihängende oder freiliegende Leitungen aneinander angeschlossen. Bekannt sind auch Leitungsführungen an einem oder mehreren der vertikalen Pfosten des Rahmengestells. Diese Leitungsführungen entsprechen oft nicht den Sicherheitsnormen und genügen vor allem nicht mehr den hohen Anforderungen, die bezüglich Bedienkomfort und ästhetischen Gesamteindruck an eine Prüfzelle gestellt werden.

Der Erfindung liegt daher die Aufgabe zugrunde, ein Rahmengestell vorzuschlagen, welches bei kostengünstiger Fertigung eine flexible geordnete und möglichst verdeckte Leitungsführung ermöglicht, die gleichzeitig den arbeits- und sicherheitstechnischen Bestimmungen genügt.

Diese Aufgabe wird erfindungsgemäß durch ein Rahmengestell mit den Merkmalen des Anspruchs 1 gelöst. Weitere vorteilhafte Ausgestaltungen der Erfindung sind den untergeordneten Ansprüchen zu entnehmen.

Grundgedanke der Erfindung ist es, die Leitungen der Prüfzelle nicht nur in den vertikalen Pfosten des Rahmengestells zu führen, sondern auch in den horizontalen Querstreben zu verlegen. Die Pfosten und Querstreben sind zu einem mechanisch stabilen Rahmengestell verbunden, das ohne weiteres mit einem schweren Prüfaufbau und mit Messgeräten belastbar ist.

Bei dem erfindungsgemäßen Rahmengestell sind die Pfosten und die Querstreben als nach außen offene Kastenprofile ausgebildet. Sie bilden Kabelkanäle zur Aufnahme von elektrischen Kabeln und/oder Leitungen für flüssige oder gasförmige Medien. Dabei sind die Querstreben in einem räumlichen Raster mit den Pfosten angeordnet und stirnseitig mit dem Pfosten verbunden.

Die horizontalen Querstreben in Form von Breiten- und Tiefenstreben sind mit den Pfosten lösbar verbunden, vorzugsweise verschraubt. Dadurch wird ein modularer Aufbau mit den Querstreben und den Pfosten als Eckpfosten und eventuell zusätzlich Zwischenpfosten in einem vorgegebenen Raster ermöglicht. Durch Variation der Länge der horizontalen Breiten- und/oder Tiefenstreben ist das Rahmengestell für unterschiedliche Anwendungsfälle einsetzbar. Dabei können an dem Rahmengestell schwenkbare Laufrollen, vorzugsweise an den Eckpfosten vorgesehen sein, um die Beweglichkeit der Prüfzelle zu gewährleisten. Als selbsttragende offene Kastenprofile können für die vertikalen Pfosten und die horizontalen Querstreben abgekantete Bleche oder stranggepresste Ein- oder Mehrkammerprofile aus Metall verwendet werden, die Kabelkanäle bilden.

Die Kastenprofile der Querstreben weisen an den beiden Endabschnitten stirnseitig Kopfplatten auf, die fest mit dem Kastenprofil verbunden sind. Die Kopfplatten bilden mit dem Kastenprofil ein Kastenelement. Dabei sind die Kopfplatten vorzugsweise aus dem gleichen Material wie die Kastenprofile hergestellt und mit geeigneten, im Handwerk üblichen Befestigungsmethoden lös-oder unlösbar fest mit dem Kastenprofil verbunden.

Zweckmäßigerweise sind die nach außen offenen Kastenprofile von der Außenseite des Rahmengestells her zugänglich und Rückwände der Profile bzw. Kastenelemente sind einem Innenraum des Rahmengestells zugewandt. Ein Vorteil ist, dass die offenen Kastenprofile einfach beispielsweise durch Abkanten von Blech und damit kostengünstig hergestellt werden können. Die Kopfplatten, die die Profile zu Kastenelementen ausbilden, wirken wie Spanten und geben den Kastenelementen eine hohe Steifigkeit. Gleichzeitig wird die durch offene Profilkonstruktion ermöglicht, Leitungen, beispielsweise zur elektrischen Verkabelung oder zur Förderung von gasförmigen oder flüssigen Medien, in den vertikalen und horizontalen Kastenprofilen oder Kastenelementen zu verlegen. Das Verlegen ist einfach und schnell möglich, die Leitungsführung kann jederzeit geändert werden, die Leitungen sind geschützt und geordnet.

Die Kastenelemente weisen an den Kopfplatten und an der zum Innenraum des Rahmengestells gerichteten Rückwand Durchführungen für die zu verlegenden Leitungen auf. Des weiteren weisen die vertikalen Pfosten an Befestigungsstellen für die Kastenelemente den stirnseitigen Durchführungen der Kastenelemente zugeordnete Durchführungen für die Leitungen auf. Damit können die Leitungen aus den Pfosten durch die Durchführungen der Pfosten und die Durchführungen in den Kopfplatten der Kastenelemente, die als Querstreben die Pfosten zu dem Rahmengestell verbinden, und weiter durch die Durchführungen in den Rückwänden der Kastenelemente den Innenraum des Rahmengestells geführt werden, ohne an irgendeiner Stelle nach außen aus dem Rahmengestell auszutreten. Selbst an den Knoten des Rahmengestells, an denen die Querstreben gegen die Pfosten stoßen, sind die Leitungen innerhalb der Profile durch die Durchführungen geführt und treten nicht aus.

Bei einer bevorzugten Ausführungsform der Erfindung weisen die Pfosten und/oder die Kastenelemente Standardlängen auf. Dies ermöglicht einen modularen und kostengünstigen Aufbau des Rahmengestells der Prüfzelle. Mit den verschiedenen Standardlängen kann der Innenraum des Rahmengestells unterschiedlich groß ausgebildet werden. Dabei können die Standardlängen der industriellen Norm für Gehäusemaße für elektrische Einrichtungen entsprechen. Es ist außerdem von Vorteil, zusätzlich die Breiten- und Tiefenmaße der Pfosten und Streben zu standardisieren. Die Standardisierung der Teile für die Herstellung des Rahmengestells ermöglicht eine kostengünstige Serienfertigung sowie eine Bevorratung der Teile, was die Bereitstellungszeit für das Rahmengestell reduziert. Trotzdem ist ein variabler Aufbau des Rahmengestells in verschiedenen Größen entsprechend den Anforderungen möglich. Außerdem ermöglicht der modulare Aufbau auch nachträglich noch eine Veränderung des Innenraums des Rahmengestells einer bestehenden Prüfzelle.

Bei einer Variante der Erfindung weist das Rahmengestell einen Schaltschrank mit standardisierten Abmessungen auf, der vorzugsweise an den vertikalen Pfosten befestigt ist. Am Schaltschrank sind den wandseitigen Durchführungen der Kastenelemente und/oder den wandseitigen Durchführungen der Pfosten zugeordnete Durchführungen für Leitungen vorgesehen.

Die Breite und die Höhe der standardisierten Schaltschränke entspricht den Standardlängen der Kastenelemente sowie dem vertikalen Raster der Befestigungsstellen an den Pfosten. Ein solcher Schaltschrank kann prinzipiell an jeder Seite des Rahmengestells angeordnet sein und dabei eine oder mehrere Querstreben ersetzen. Wie von den Pfosten in die Querstreben können Leitungen aus oder in den Schaltschrank durch die Durchführungen in die Pfosten oder Querstreben geführt werden ohne auszutreten.

Bei einer bevorzugten Ausführungsform der Erfindung weist das Rahmengestell eine Trägerplatte mit einem Prüfaufbau auf. Dabei ist die Trägerplatte für eine gute Zugänglichkeit zu dem Prüfaufbau idealerweise in einem mittleren oder oberen Bereich des Rahmengestells angeordnet. Für den Fall, dass ein Schaltschrank vorgesehen ist, vorzugsweise oberhalb des integrierten Schaltschrankes. Außerdem weist das Rahmengestell zweckmäßigerweise eine Stellplatte für Messgeräte auf, die vorzugsweise an einem dem Boden fernen oberen Ende der Pfosten, d.h. oberhalb des Pruftaufbaus angeordnet ist. Dabei können die Trägerplatte und oder die Stellplatte an den vertikalen Pfosten und/oder an den horizontalen Querstreben befestigt sein. Die Größe der Trägerplatte sowie der Stellplatte ist ebenfalls standardisiert.

Zum Verschließen der nach außen offenen Kastenprofile der Pfosten und der Querstreben können Abdeckungen bei dem erfindungsgemäßen Rahmengestell vorgesehen sein, wie sie bei Kabelkanälen üblich sind. Die Abdeckungen schützen die im Rahmengestell verlegten Leitungen und werten die Prüfzelle optisch auf.

Nachfolgend wird die Erfindung anhand eines in der Zeichnung dargestellten Ausführungsbeispiels näher erläutert. Weitere Merkmale der Erfindung ergeben sich aus der folgenden Beschreibung des Ausführungsbeispiels der Erfindung in Verbindung mit den Ansprüchen und der beigefügten Zeichnung. Die einzelnen Merkmale können für sich allein oder zu mehreren in beliebiger Kombination bei unterschiedlichen Ausführungsformen der Erfindung verwirklicht sein. Es stellen dar:
- Figur 1: ein erfindungsgemäßes Rahmengestell für eine Prüfzelle in perspektivischer Ansicht; und
- Figur 2: das Rahmengestell aus Figur 1 als Explosivzeichnung.

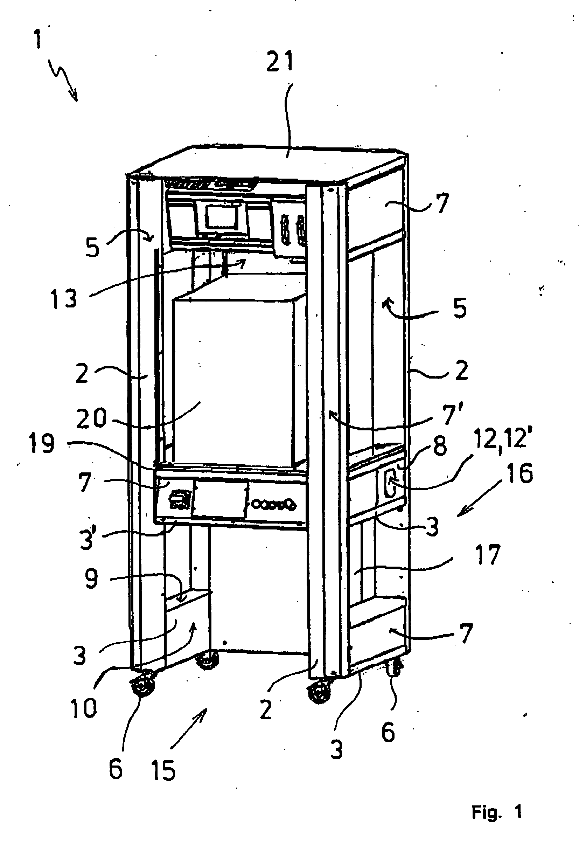

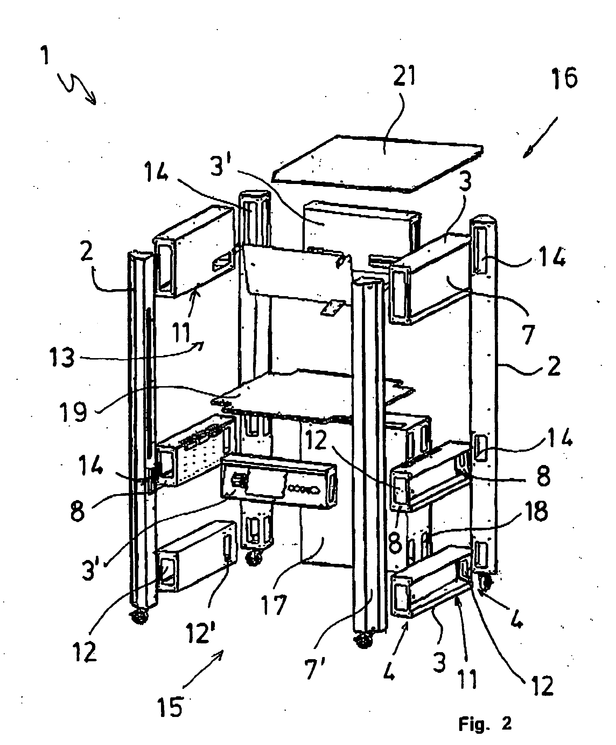

Das in den Figuren 1, 2 dargestellte erfindungsgemäße Rahmengestell 1 für eine Prüfzelle weist vier vertikale Pfosten 2 als Eckpfosten sowie auf jeder Seite eine oder mehrere Querstreben 3, 3' auf, die zwischen den Eckpfosten 2 angeordnet sind. Die Querstreben 3, 3' sind an ihren Stirnenden 4 mit Seitenwänden 5 der Eckpfosten 2 durch in der Zeichnung nicht dargestellte Schrauben und Muttern lösbar verbunden. Das Rahmengestell 1 wird von Laufrollen 6 getragen, die unten an den Eckpfosten 2 angebracht sind. Die Eckpfosten 2 und die Querstreben 3, 3' weisen nach außen offene Kastenprofile auf, die Kabelkanäle bilden und mit abnehmbaren Abdeckungen 7, 7' verschlossen sind.

Die Eckpfosten 2 und die Querstreben 3, 3' sind tragende Teile eines modularen Baukastensystems. Dazu sind die Pfosten 2 und die Querstreben 3, 3' sowie die zugehörigen Abdeckungen 7, 7' in ihren Abmessungen standardisiert. Ihre Standardlängen orientieren sich an genormten Abmessungen für gebräuchliche industrielle Gehäusegrößen von elektrischen Einrichtungen.

Die Kastenprofile der Querstreben 3, 3' sind stirnseitig jeweils mit Kopfplatten 8 versehen, die fest mit Seitenwänden 9 und einer Rückwand 10 der Kastenprofile verbunden sind. Mit den Kopfplatten 8 bilden die Kastenprofile der Querstreben 3, 3' nach außen offene Kastenelemente 11. Die Kopfplatten 8 der Kastenelemente 11 weisen je eine Durchführung 12 für in den Kastenelementen 11 zu verlegende elektrische, pneumatische oder hydraulische Leitungen auf, die in der Zeichnung nicht dargestellt sind. Außerdem weisen die einem Innenraum 13 des Rahmengestells 1 zugewandten Rückwände 10 der als Querstreben 3, 3' verwendeten Kastenelemente 11 weitere Durchführungen 12' auf, durch die Leitungen aus dem Kastenelement 11 in den Innenraum 13 des Rahmengestells 1 austreten können.

Die Kastenelemente 11 können mit ihren Kopfplatten 8 nur an bestimmten Befestigungsstellen an den Seitenwänden 5 der Eckpfosten 2 befestigt werden. An den in einem bestimmten Raster vorgesehenen Befestigungsstellen für die Kastenelemente 11 sind den Durchführungen 12 der Kopfplatten 8 zugeordnete Durchführungen 14 für den Durchtritt der nicht dargestellten Leitungen aus den Pfosten 2 in die Querstreben 3, 3' ausgebildet. Die Durchführungen 12 in den Kopfplatten 8 sind deckungsgleich mit den Durchführungen der Pfosten 2 angeordnet.

Zwischen einer Vorderseite 15 und einer Rückseite 16 des Rahmengestells 1 erstrecken sich jeweils drei Kastenelemente 11 als horizontale Tiefenstreben 3. Die Tiefenstreben 3 sind jeweils unten, oben und in etwa mittlerer Höhe an den Eckpfosten 2 befestigt. Die Eckpfosten 2 an der Vorderseite 15 sind mit zwei Breitenstreben 3' verbunden. Die Breitenstreben 3' der Vorderseite 15 verlaufen auf Höhe der oberen und mittleren Tiefenstreben 3. An der Rückseite 16 des Rahmengestells 1 ist nur oben an den Eckpfosten 2 eine Breitenstrebe 3' vorgesehen. An die Stelle einer unteren Breitenstrebe 3' tritt dort ein Schaltschrank 17, der in der Breite der Länge der Kastenelemente 11 entspricht. Die angegebene Anzahl und Anordnung der Querstreben 3, 3' und des Schaltschranks 17 ist nicht zwingend sondern durch den modularen Aufbau variabel.

Der Schaltschrank 17 ist stirnseitig an den zugewandten Seitenwänden 5 der Eckpfosten 2 befestigt. Er weist Durchführungen 18 auf der Höhe der unteren und mittleren Tiefenstreben 3 auf, die deckungsgleich mit den entsprechenden Durchführungen 14 der Pfosten 2 sowie jeweils einer Durchführung 12' der Tiefenstreben 3 ausgebildet und angeordnet sind. Der Schaltschrank 17 ist ebenso wie die Kastenelemente 11 stirnseitig mit den Eckpfosten 2 des Rahmengestells 1 verschraubt.

Auf Höhe der mittleren Querstreben 3, 3' ist eine Trägerplatte 19 mit einem schematisch als Kasten dargestellten Prüfaufbau 20 montiert. Die Trägerplatte 19 stützt sich mit äußeren Randbereichen auf einer oberen Seitenwand 9 der Kastenelemente 11 ab. Des weiteren ist auf Höhe der oberen Querstreben 3, 3' eine Stellplatte 21 für in der Zeichnung nicht dargestellte Messgeräte vorgesehen. Die Stellplatte 21 liegt wie die Trägerplatte 19 auf den Querstreben 3, 3' auf. Außerdem stützt sich die Stellplatte 21 auf den oberen Stirnseiten 22 der Pfosten 2 ab. Die Trägerplatte 19 sowie die Stellplatte 21 sind mit den Querstreben 3, 3' verschraubt.

Bei abgenommenen Abdeckungen 7, 7' können Leitungen ausgehend von dem Schaltschrank 17 in den vertikalen Pfosten 2 sowie in den horizontalen Streben 3, 3' bis zu dem Prüfaufbau 20 und/oder zu der Stellplatte 21 mit den Prüfgeräten verlegt werden. Dabei werden die Leitungen durch die Durchführungen 18, 14, 12, 12' des Schaltschrankes 17 der Eckpfosten 2 und der Streben 3, 3' geführt. Nach dem Verschluss der Kastenprofile mittels der Abdeckungen 7, 7' sind die Leitungen unsichtbar und geschützt, sie treten an keiner Stelle nach außen aus den Pfosten 2 und Streben 3, 3' aus dem Rahmengestell 1 aus, sondern nur durch die Durchführungen 12' in den Rückwänden der Streben 3, 3' in den Innenraum 13 des Rahmengestells 1 direkt zum Prüfaufbau 20 und zu den nicht dargestellten Messgeräten auf der Stellplatte 21.

## Patentansprüche

1. Rahmengestell (1) für eine Prüfzelle, mit vertikalen Pfosten (2) und horizontalen Querstreben (3, 3'), wobei die Querstreben (3, 3') an ihren Enden (4) mit den Pfosten (2) verbunden, die Pfosten (2) und die Querstreben (3, 3') als nach außen offene Kastenprofile ausgebildet und die Querstreben (3, 3') in einem räumlichen Raster stirnseitig mit den Pfosten (2) verbunde sind, **dadurch gekennzeichnet, dass** die Kastenprofile der Querstreben (3, 3') stirnseitig Kopfplatten (8) aufweisen, die fest mit dem Kastenprofil verbunden sind und mit dem Kastenprofil ein Kastenelement (11) bilden, dass die Kastenelemente (11) an den Kopfplatten (8) und an einer zu einem Innenraum (13) des Rahmengestells (1) gerichteten Wand (9, 10) der Kastenelemente (11) Durchführungen (12, 12') für Leitungen aufweisen, und dass die Pfosten (2) an Befestigungsstellen für die Kastenelemente (11) den Durchführungen (12) der Kopfplatten (8) zugeordnete Durchführungen (14) für den Durchtritt von Leitungen aufweisen.

2. Rahmengestell nach Anspruch 1, **dadurch gekennzeichnet, dass** die Pfosten (2) und/oder die Kastenelemente (11) Standardlängen aufweisen.

3. Rahmengestell nach einem der vorangegangenen Ansprüche, **dadurch gekennzeichnet, dass** das Rahmengestell (1) einen Schaltschrank (17) mit standardisierten Abmessungen aufweist, bei dem Durchführungen (18) für Leitungen vorgesehen sind, die zu den Durchführungen (12, 12') der Kastenelemente (11) und/oder der Pfosten (2) korrespondierend ausgebildet und angeordnet sind.

4. Rahmengestell nach einem der vorangegangenen Ansprüche, **dadurch gekennzeichnet, dass** das Rahmengestell (1) eine Trägerplatte (19) mit einem Prüfaufbau (20) aufweist.

5. Rahmengestell nach einem der vorangegangenen Ansprüche, **dadurch gekennzeichnet, dass** das Rahmengestell (1) eine Stellplatte (21) für Messgeräte aufweist, die vorzugsweise an einem vom Boden entfernten Ende (22) der Pfosten (2) angeordnet ist.

6. Rahmengestell nach einem der vorangegangenen Ansprüche, **dadurch gekennzeichnet, dass** zum Verschließen der nach außen offenen Kastenprofile der Pfosten (2) und der Querstreben (3, 3') Abdeckungen (7, 7') vorgesehen sind.

## Claims

1. A rack (1) for a test cell, comprising vertical posts (2) and horizontal crossbars (3, 3'), the crossbars (3, 3') being connected with ends (4) to the posts (2), wherein the posts (2) and the crossbars (3, 3') are shaped as box sections that are open towards the outside and wherein the crossbars (3, 3') are arranged in a spatial grid and are connected on the face side to the posts (2), **charcterized in that** the box sections of the crossbars (3, 3') have on the face end plates (8) being attached permanently to the box section and forming a box element (11) together with the box section, wherein the box elements (11) have passages (12, 12') for lines at the end plates (8) and at a wall (9, 10) facing the interior space (13) of the rack (1), and wherein the posts (2) have passages (14) for lines at attachment points for the box elements (11), being associated with the passages (12) of the end plates (8).

2. A rack as claimed in Claim 1, **charcterized in that** the posts (2) and/or the box elements (11) have standard lengths.

3. A rack as claimed in one of the above mentioned claims, **charcterized in that** the rack (1) has a control cabinet (17) of standardized dimensions in which passages (18) for lines are provided that are shaped and arranged to correspond with the passages (12, 12') of the box elements (11) and/or the posts (2).

4. A rack according to one of the above mentioned claims, **charcterized in that** the rack (1) has a support panel (19) with testing apparatus (20).

5. A rack according to one of the above mentioned claims, **charcterized in that** the rack (1) has a shelf panel (21) for instruments that preferably located at a remote end (22) of the posts (2) in relation to the floor.

6. A rack according to one of the above mentioned claim, **charcterized in that** covers (7, 7') are provided for closing the box sections of the posts (2) and crossbars (3, 3') that are open towards the outside.

## Revendications

1. Châssis (1) pour une cellule d'essai, comprenant des poteaux verticaux (2) et des entretoises horizontales (3, 3'), lesdites entretoises horizontales (3, 3') étant reliées auxdits poteaux (2) par leurs extrémités, lesdits poteaux (2) et lesdites entretoises (3, 3') étant réalisés sous la forme de profilés en caisson ouverts vers l'extérieur, et lesdites entretoises (3, 3') étant reliées frontalement auxdits poteaux (2) selon un quadrillage tramé dans l'espace, **caractérisé par le fait que** les profilés en caisson des entretoises (3, 3') présentent, aux faces extrêmes, des panneaux frontaux (8) qui sont reliés rigidement au profilé en caisson, et forment un élément (11) en caisson avec ledit profilé en caisson ; **par le fait que** les éléments (11) en caisson comportent, sur les panneaux frontaux (8) et sur une paroi (9, 10) desdits éléments (11) en caisson qui est dirigée vers un espace intérieur (13) du châssis (1), des traversées (12, 12') destinées à des conducteurs ; et **par le fait que** les poteaux (2) présentent, dans des zones de fixation destinées aux éléments (11) en caisson, des traversées (14) affectées au passage de conducteurs et associées aux traversées (12) des panneaux frontaux (8).

2. Châssis selon la revendication 1, **caractérisé par le fait que** les poteaux (2) et/ou les éléments (11) en caisson offrent des longueurs normalisées.

3. Châssis selon l'une des revendications précédentes, **caractérisé par le fait que** ledit châssis (1) présente une armoire de commutation (17) à cotes normalisées, dans laquelle sont prévues des traversées (18) destinées à des conducteurs, qui sont réalisées et agencées en concordance avec les traversées (12, 12') des éléments (11) en caisson et/ou des poteaux (2).

4. Châssis selon l'une des revendications précédentes, **caractérisé par le fait que** ledit châssis (1) comporte un panneau de support (19) à structure d'expérimentation (20) rapportée.

5. Châssis selon l'une des revendications précédentes, **caractérisé par le fait que** ledit châssis (1) présente un reposoir (21) dédié à des appareils mesureurs et disposé, de préférence, à une extrémité (22) des poteaux (2) qui est éloignée du fond.

6. Châssis selon l'une des revendications précédentes, **caractérisé par le fait que** des caches (7, 7') sont prévus pour obturer les profilés en caisson, ouverts vers l'extérieur, des poteaux (2) et des entretoises (3, 3').
